(19) Europäisches Patentamt
European Patent Office
Office européen des brevets

(11) **EP 0 910 119 B1**

(12) **EUROPEAN PATENT SPECIFICATION**

(45) Date of publication and mention
of the grant of the patent:
**03.06.2009 Bulletin 2009/23**

(51) Int Cl.:
***H01L 21/316*** (2006.01)          ***H01L 21/311*** (2006.01)
***H01L 21/28*** (2006.01)          ***H01L 21/3205*** (2006.01)

(21) Application number: **98308341.1**

(22) Date of filing: **13.10.1998**

(54) **Method for oxidizing a structure during the fabrication of a semiconductor device**

Verfahren zum Oxidieren einer Struktur während der Herstellung einer Halbleitervorrichtung

Méthode d'oxydation d'une structure durant la fabrication d'un dispositif semiconducteur

(84) Designated Contracting States:
**DE FR GB IT NL**

(30) Priority: **14.10.1997 US 61827 P**

(43) Date of publication of application:
**21.04.1999 Bulletin 1999/16**

(60) Divisional application:
**09153586.4 / 2 063 464**

(73) Proprietor: **Texas Instruments Incorporated**
**Dallas, TX 75265 (US)**

(72) Inventors:
• **Lin, Boyang**
**Richardson, TX 75081 (US)**
• **Hwang, Ming**
**Dallas, TX 6927 (US)**
• **Niuya, Takayuki**
**Tsukuba-shi, Tsukuba 305-00 (JP)**
• **Park, Song**
**Plano, TX 75025 (US)**

(74) Representative: **Holt, Michael**
**Texas Instruments Limited**
**European Patents Department**
**800 Pavilion Drive**
**Northampton NN4 7YL (GB)**

(56) References cited:
**US-A- 5 257 926**

• **PATENT ABSTRACTS OF JAPAN vol. 017, no. 173 (E-1345), 2 April 1993 (1993-04-02) -& JP 04 328862 A (HITACHI LTD), 17 November 1992 (1992-11-17)**
• **PATENT ABSTRACTS OF JAPAN vol. 1995, no. 06, 31 July 1995 (1995-07-31) -& JP 07 066408 A (TOSHIBA CORP), 10 March 1995 (1995-03-10)**
• **PATENT ABSTRACTS OF JAPAN vol. 009, no. 295 (E-360), 21 November 1985 (1985-11-21) & JP 60 134441 A (HITACHI SEISAKUSHO KK), 17 July 1985 (1985-07-17)**
• **IWATA S ET AL: "A new tungsten gate process for VLSI application" IEEE TRANSACTIONS ON ELECTRON DEVICES, SEPT. 1984, USA, vol. ED-31, no. 9, pages 1174-1179, XP000971067 ISSN: 0018-9383**
• **YAMAMOTO N ET AL: "Tungsten gate electrode and interconnect for MOS VLSIs" EXTENDED ABSTRACTS OF THE 15TH CONFERENCE ON SOLID STATE DEVICES AND MATERIALS, TOKYO, JAPAN, 30 AUG.-1 SEPT. 1983, pages 217-220, XP000955309 1983, Tokyo, Japan, Japan Soc. Appl. Phys, Japan ISBN: 4-930813-04-2**
• **PATENT ABSTRACTS OF JAPAN vol. 010, no. 117 (E-400), 2 May 1986 (1986-05-02) & JP 60 250630 A (HITACHI SEISAKUSHO KK), 11 December 1985 (1985-12-11)**
• **PATENT ABSTRACTS OF JAPAN vol. 009, no. 118 (E-316), 23 May 1985 (1985-05-23) & JP 60 009166 A (HITACHI SEISAKUSHO KK), 18 January 1985 (1985-01-18)**

**Description**

FIELD OF THE INVENTION

The present invention pertains to semiconductor devices, and more specifically, to a method for oxidizing or reoxidizing a structure during the fabrication of a semiconductor device.

BACKGROUND OF THE INVENTION

As device dimensions continue to decrease to achieve higher density and performance, there is an increasing demand for highly conductive gate structures, interconnects, and electrodes for metal on silicon (MOS) devices. The polycrystalline silicon ("poly" or "polysilicon") used for these purposes in conventional processes has several limitations, due mainly to its higher resistivity.

Recently, various metal silicides have been considered because they have a conductivity which is higher than that of polysilicon by about an order of magnitude. However, future devices with very high integration densities will, most likely, need to be fabricated with higher conductivity materials for gate structures and interconnects. Therefore, either all metal structures will need to be formed or structures which are comprised of polysilicon and a refractory metal (such as tungsten, molybdenum, cobalt and/or titanium).

With regards to the formation of a gate structure, a thermal oxidation step is needed after the gate patterning, especially for memory devices. This oxidation step is needed to remove damage caused by the patterning and etching of the gate structure (primarily at the gate edges) by reactive ion etching (RIE) and to thicken the gate oxide on the edge so as to improve its reliability and reduce sharp corners at the lower edges of the conductive gate structure. If a polysilicon and tungsten gate structure is used, this oxidation step may create problems because tungsten easily oxidizes at temperatures greater than around 350°C in an oxygen ambient.

A solution to this problem involves using $H_2$ and $H_2O$ to oxidize any existing silicon or silicon oxide surfaces while leaving any tungsten surfaces unoxidized. *See* K. Nakajima, et al., Poly-metal Gate Process --- Ultrathin WSiN Barrier Layer Impermeable to Oxidant In-diffusion during Si Selective Oxidation, CONFERENCE PROCEEDINGS ULSI XI, 1996 MATERIALS RESEARCH SOCIETY 317-323 (1996). A problem with this approach is that a very small amount of water can be used and it is extremely difficult to controllably introduce such small amounts of water in large scale production of semiconductor devices.

SUMMARY OF THE INVENTION

The selective oxidation method disclosed herein involves the oxidation of one material ($M_1$) without substantially oxidizing another material ($M_2$). The chemical reactions for the oxidation of $M_1$ and $M_2$ are (using $O_2$ as the oxidizer) :

$$2M_1 + O_2 \rightarrow 2M_1O + E_1 \qquad (1)$$

$$2M_2 + O_2 \rightarrow 2M_2O + E_2 \qquad (2)$$

where $E_1$ and $E_2$ are the enthalpies of formation for reactions (1) and (2), respectively. In order to achieve this selective oxidation, a combination of an oxidizer, preferably $O_2$, and a reducer, $H_2$, are utilized. The minimum requirement for the successful selective oxidation of $M_1$ while not appreciably oxidizing $M_2$ is that reaction (1) is favored as compared to reaction (2). In other words, $E_1$ is less than $E_2$. In the case where $M_1$ represents silicon, polycrystalline silicon, or amorphous silicon and $M_2$ represents tungsten,

$$Si + O_2 \rightarrow SiO_2 - 911 \text{ kJ/mol} \qquad (3)$$

$$(2/3)W + O_2 \rightarrow (2/3)WO_3 - 562 \text{ kJ/mol} \qquad (4)$$

Hence, since $E_1$ is less than $E_2$ (-911 kJ/mol versus -562 kJ/mol), the silicon of reaction (3) will oxidize much more readily than the tungsten of reaction (4).

A method of fabricating a capacitor having a dielectric between a bottom electrode and a top electrode and situated over a semiconductor substrate is provided. The method comprises the steps of: providing the bottom electrode over the semiconductor substrate; providing an oxidizable dielectric material over the bottom electrode; and subjecting the bottom electrode and the oxidizable dielectric material to an explosive reaction between $O_2$ and $H_2$ in a semiconductor processing chamber, wherein the oxidizable dielectric material is oxidized and the bottom electrode remains substantially unoxidized, such that the reaction between the $O_2$ and $H_2$ does not increase the pressure in the processing chamber beyond a predetermined safe level. The dielectric material is, preferably, comprised of a material selected from the group consisting of: an oxide/nitride stack, BST, tantalum pentoxide, PZT, or any combination thereof.

BRIEF DESCRIPTION OF THE DRAWINGS

The present invention will now be further described, by way of example, with reference to the accompanying drawings in which:

   FIGURE 1 is cross-sectional view of a device formed using a method of fabrication;
   FIGURE 2 is a TEM photograph of devices formed using the method of fabrication;
   FIGURE 3 is a cross-sectional view of a memory cell formed using the method of an alternative method of fabricating and;
   FIGURE 4 is a graph illustrating the sheet resistivity of a Tungsten layer.

DETAILED DESCRIPTION OF THE DRAWINGS

A method of oxidizing selective materials such as silicon (single crystal, polycrystalline, or amorphous silicon) without appreciably oxidizing any other materials (such as a tungstride or tungsten nitride structure) is disclosed herein. In one embodiment the oxidation is performed by introducing hydrogen gas and oxygen gas into a chamber where the semiconductor wafer resides and heating the wafer and/or the chamber. Note, however, that the introduction of hydrogen gas along with oxygen gas can be very volatile.

In order to safely oxidize the desired structure while leaving other structures (preferably the refractory metals) unoxidized using oxygen and hydrogen gases, the system pressure should not exceed its safety limit in the presence of the following reaction

$$2H_2 + O_2 \rightarrow 2\,H_2O + E \qquad\qquad (5)$$

where E is the enthalpy generated by this reaction.

If the system/chamber is first filled with $H_2$ and $O_2$ before reaction (5) takes place, then the final pressure of the system is given by:

$$\mathrm{P = P_0 * [1 + (T/T_0)]} \qquad\qquad (1)$$

where T = E/(heat capacitance of the resulting gas system), P is the ending pressure, $P_0$ is the starting pressure of the system, $T_0$ is the starting temperature, and the heat capacitance is a function of the $O_2$ to $H_2$ ratio (and assuming it is independent of the temperature). For example, starting at 500°C with a constant volume mix of $O_2$ in $H_2$ (ratio of 1:10) and an initial pressure of 200 Torr (1 Torr = 133 Pa), the final pressure of the system (using equation (1)) is about 600 Torr which is less than the pressure of the atmosphere. Therefore, this process should be safe.

If reaction (5) occurs as $H_2$ and $O_2$ are entered into the system, then the reaction occurs in only part of the volume of the chamber. By doing this, the safety of the process is improved and the process window can be enlarged because the reaction occurs in only a portion of the total volume of the process chamber thereby leaving the rest of the volume available for expansion. In this case, reaction (5) occurs continuously as the gases enter into the chamber instead of filling the entire chamber with the gases before ignition of the gases.

A variation of this approach is to start the reaction at a lower pressure and increase the pressure once the reaction starts. Anther variation involves starting the reaction at a lower concentration of one gas (such as $O_2$) and increasing the concentration once the reaction starts.

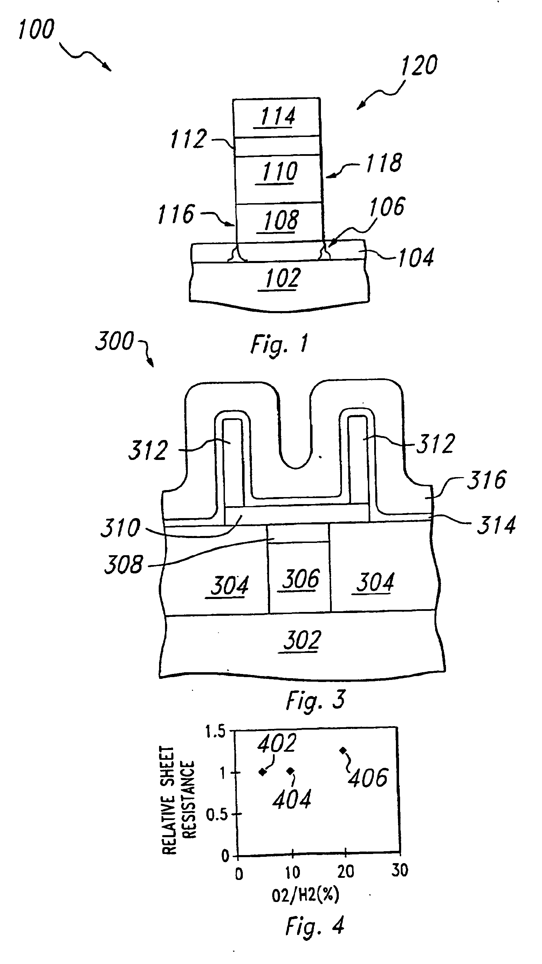

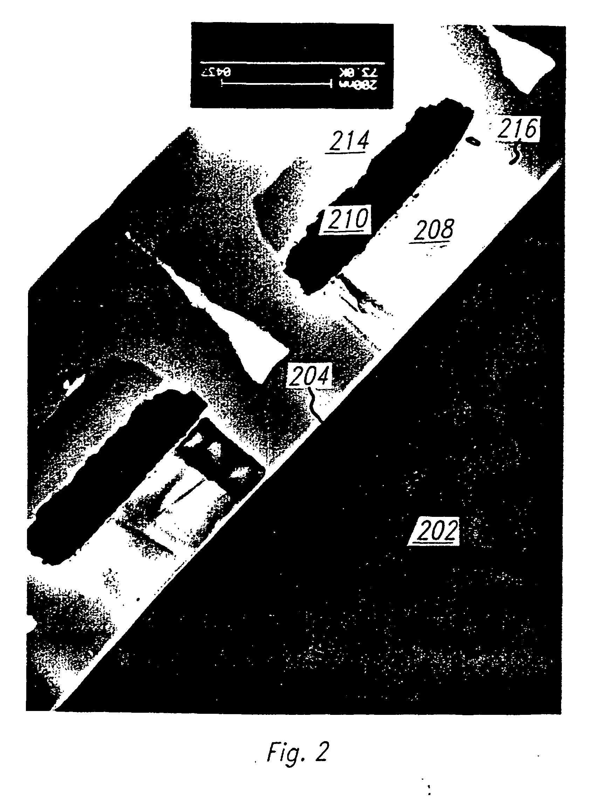

FIGUREs 1 and 2 illustrate a transistor formed using such a method. After gate insulating layer 104 (preferably an oxide layer -- more preferably $SiO_2$) is formed, a semiconductive layer (preferably insitu doped, exsitu doped, or undoped polysilicon) is formed (preferably deposited by chemical vapor deposition). Next, a metal layer is formed (preferably deposited). Preferably, the metal layer is comprised of a refractory metal (preferably tungsten, cobalt, aluminum, or titanium) formed over a nitride layer (preferably comprised of the refractory metal and nitrogen -- more preferably tungsten nitride). This is followed by the formation of a nitride layer (preferably comprised of silicon and nitride - more preferably $Si_4N_3$).

Next, these layers are etched to form gate structure 120 (preferably comprised of polysilicon structure 108, tungsten nitride structure 110, tungsten structure 112, and silicon nitride structure 114). Preferably, this etch step is performed by reactive ion etch (RIE) but it can be accomplished using any standard processing step. One drawback to this etch step, especially when RIE is used, is that it may degrade the gate dielectric at locations 106. If left untreated, this may increase the leakage of the device or may lower the gate oxide integrity (GOI) thereby rendering the device non-functional or damaged. Using conventional oxidation methods, the damaged portions of gate insulating layer 104 are reoxided along with the oxidation of surfaces 116 of polysilicon structure 108 and surfaces 118 of metal structure 110 and 112. In fact, it may even entirely oxidize metal structures 110 and 112. This will severely degrade the device because the conductivity of the resulting structure (including layers 110 and 112) may greatly decrease due to the oxidation of the metal (especially where the metal is tungsten). Oxidation of metal structures 110 and 112 may also cause peeling. The method disclosed herein allows for the reoxidation of layer 104 and the oxidation of silicon-containing structure 108 while leaving metal structure 112 (preferably comprised of W, Ti, Co, Cu, or Al) and metal-nitride structure 110 (preferably comprised of a nitride and a refractory metal such as W, Ti, Co, Cu, or Al - more preferably tungsten nitride) substantially unoxidized. This is shown in FIGURE 2 where region 208 is equivalent to region 108, region 210 is equivalent to regions 110 and 112, region 214 is equivalent to region 114 and region 216 illustrates the formed oxide regions on the side of region 208.

In a method of fabrication, this oxidation step is accomplished by providing around 12% $O_2$ and $H_2$ into a chamber in which the wafer is provided. The pressure within the chamber is preferably around 100 Torr and the temperature is around 1000°C. Using this embodiment for around 60 to 80 seconds (preferably 70 seconds) will result in around 3 nm of oxide to be formed on bare silicon and thin silicon oxide, and it will result in around 6 to 10 nm of oxide to be grown on polysilicon structures. While these specific conditions are preferred, the temperature, pressure, time, and amount of oxygen versus that of hydrogen can be changed so as to grow more or less of an oxide film so long as oxidation of the silicon or silicon oxide structure is accomplished while not substantially oxidizing the metal or metal nitride structures.

This method of fabrication may be implemented to selectively oxidize silicon structures in the presence of tungsten under the following conditions: the ambient temperature is between 300 and 1200°C; the pressure is around 1 Torr to 10 atmospheric pressure; the oxidizer to reducer ratio, $O_2$ to $H_2$ ratio, respectively, is around 0.1% to 99.9%; and the duration is around 1 second to 10 hours.

In an alternative method of fabrication, the mixture of hydrogen and oxygen can be used to selectively oxidize a particular material (such as $Ta_2O_5$ or BST) without oxidizing other materials which are present (such as copper, tungsten, platinum, or other refractory metal or conductive structure which may be used to make an electrode of a memory cell) in developing electronic devices (such as the memory cell of a DRAM). This particular selective oxidation method can be accomplished by using an $O_2$ and $H_2$ ambient to oxidize a capacitor dielectric. While this alternative method is preferably performed as a rapid thermal process step with relatively low ambient pressures, it can be implemented in many ways. An advantage of this method is that it may be implemented using a lower thermal budget (preferably, the temperatures required will be around 400 to 1000°C) and it can be used so as to oxidize the capacitor dielectric while leaving other features (such as tungsten, platinum, copper, or other similar materials) substantially unoxidized.

Preferably, this alternative method of fabrication may be implemented under the following conditions: the ambient temperature is between 300 and 1200°C; the pressure is around 1 Torr to 10 atmospheric pressure; the oxidizer to reducer ratio, $O_2$ to $H_2$ ratio, respectively, is around 0.1% to 99.9%; and the duration is around 1 second to 10 hours.

FIGURE 3 illustrates a memory cell which is fabricated using the method disclosed herein. The memory cell can be formed either over or under the bitline, and it may either be formed as a "crown cell" or as a planar cell and it may or may not be formed of rugged polysilicon or hemispherical grain polysilicon. The memory cell of FIGURE 3 is comprised of substrate 302, interlevel dielectric 304, conductive plug 306 (preferably comprised of doped single-crystal or polycrystalline silicon), bottom electrode base 310 and upright portions 312, dielectric layer 314 and top electrode 316. Basically, the method can be used to either form dielectric 314 and/or to prevent the oxidation of bottom electrode 310 and 312. More specifically, if conductive plug 306 and electrode 310 and 312 are formed of tungsten and if the dielectric material requires a high temperature anneal in an oxygen containing ambient (such as $Ta_2O5$ and BST require), then the method disclosed may be utilized to prevent the oxidation of these features. Preferably, this is accomplished using the following conditions: the ambient temperature is between 300 and 1200°C; the pressure is around 1 Torr to 10 atmospheric pressure; the oxidizer to reducer ratio, $O_2$ to $H_2$ ratio, respectively, is around 0.1% to 99.9%; and the duration is around 1 second to 10 hours.

An alternative method of fabrication can be used to form the capacitor dielectric 314 or to reoxidize capacitor dielectric so as to enhance it properties. Preferably, dielectric 314 is formed or reoxided by subjecting the wafer to a mixture of $H_2$ and $O_2$. Preferably, this is accomplished using the following conditions: the ambient temperature is between 300 and 1200°C; the pressure is around 1 Torr to 10 atmospheric pressure; the oxidizer to reducer ratio, $O_2$ to $H_2$ ratio, respectively, is around 0.1% to 99.9%; and the duration is around 1 second to 10 hours.

FIGURE 4 is a graph illustrating relative sheet resistivity of a tungsten layer which is approximately 60 nm thick and is subjected to the oxidation step of the method disclosed herein versus the percentage of $O_2/H_2$ mixture. The pressure is around 100 Torr at around 1000°C. Points 402 and 404 illustrate that the sheet resistivity of a tungsten layer subjected to an oxidation step of the method disclosed herein, where the $O_2/H_2$ mixture is 10% or less, has the same sheet resistivity as a tungsten layer which has not been subjected to an oxidation step. Point 406 illustrates that the sheet resistivity of a tungsten layer subjected to an oxidation step of the instant invention, where the $O_2/H_2$ mixture is around 20%, has a sheet resistivity around 20% higher than that of an untreated tungsten layer.

**Claims**

1. A method of fabricating, in a semiconductor processing chamber, a capacitor having a dielectric between a bottom electrode and a top electrode and situated over a semiconductor substrate, said method comprising the steps of:

   providing said bottom electrode over said semiconductor substrate;
   providing an oxidizable dielectric material over said bottom electrode; and
   subjecting said bottom electrode and said oxidizable dielectric material to a reaction between $O_2$ and $H_2$ in the semiconductor processing chamber, wherein said oxidizable dielectric material is oxidized and said bottom electrode remains substantially unoxidized, such that the reaction between said $O_2$ and $H_2$ does not increase the pressure in the processing chamber beyond a predetermined safe level.

2. The method of Claim 1, wherein said step of providing an oxidizable dielectric material comprises providing a dielectric material selected from the group consisting of: an oxide/nitride stack, BST, tantalum pentoxide, PZT, or any combination thereof.

**Patentansprüche**

1. Verfahren zur in einer Halbleiterbearbeitungskammer erfolgenden Herstellung eines Kondensators, der zwischen einer unteren Elektrode und einer oberen Elektrode ein Dielektrikum aufweist und über einem Halbleitersubstrat liegt, wobei das Verfahren die folgenden Schritte umfasst:

   die untere Elektrode wird über dem Halbleitersubstrat bereitgestellt,
   ein oxidierbares dielektrisches Material wird über der unteren Elektrode bereitgestellt, und
   die untere Elektrode und das oxidierbare dielektrische Material werden in der Halbleiterbearbeitungskammer einer Reaktion zwischen $O_2$ und $H_2$ unterzogen, wobei das oxidierbare dielektrische Material oxidiert wird und die untere Elektrode im wesentlichen nichtoxidiert bleibt, derart, dass die Reaktion zwischen dem $O_2$ und dem $H_2$ den Druck in der Bearbeitungskammer nicht über ein vorbestimmtes sicheres Niveau hinaus erhöht.

2. Verfahren nach Anspruch 1, bei dem der Schritt, bei dem ein oxidierbares dielektrisches Material bereitgestellt wird, die Bereitstellung eines dielektrischen Materials umfasst, das aus der aus einem Oxid/Nitrid-Stapel, BST, Tantal (V)-oxid, PZT bzw. einer Kombination daraus bestehenden Gruppe ausgewählt ist.

**Revendications**

1. Procédé de fabrication, dans une chambre de traitement de semiconducteurs, d'un condensateur comprenant un diélectrique entre une électrode inférieure et une électrode supérieure et situé sur un substrat semi-conducteur, ledit procédé comprenant les étapes suivantes :

   fournir ladite électrode inférieure sur ledit substrat semi-conducteur ;
   fournir un matériau diélectrique oxydable sur ladite électrode inférieure ; et
   soumettre ladite électrode inférieure et ledit matériau diélectrique oxydable à une réaction entre $O_2$ et $H_2$ dans la chambre de traitement de semiconducteurs, où ledit matériau diélectrique oxydable est oxydé et ladite électrode inférieure reste sensiblement non oxydée, de sorte que la réaction entre lesdits $O_2$ et $H_2$ n'augmente pas la pression dans la chambre de traitement au-delà d'un niveau de sécurité prédéterminé.

2. Procédé selon la revendication 1, dans lequel ladite étape de production d'un matériau diélectrique oxydable consiste à fournir un matériau diélectrique sélectionné parmi le groupe comprenant : un empilement d'oxyde/nitrure, du BST, du pentoxyde de tantale, du PZT ou l'une quelconque de leurs combinaisons.

Fig. 1

Fig. 3

Fig. 4

Fig. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **K. Nakajima et al.** Poly-metal Gate Process --- Ultrathin WSiN Barrier Layer Impermeable to Oxidant In-diffusion during Si Selective Oxidation. *CONFERENCE PROCEEDINGS ULSI XI, 1996 MATERIALS RESEARCH SOCIETY,* 1996, 317-323